(19) Europäisches Patentamt
European Patent Office
Office européen des brevets

(11) **EP 4 629 810 A1**

(12) **EUROPEAN PATENT APPLICATION**
published in accordance with Art. 153(4) EPC

(43) Date of publication:
**08.10.2025 Bulletin 2025/41**

(21) Application number: **23897415.8**

(22) Date of filing: **08.11.2023**

(51) International Patent Classification (IPC):
*H10N 30/045* (2023.01)    *H10N 30/06* (2023.01)
*H10N 30/20* (2023.01)    *H10N 30/50* (2023.01)
*H10N 30/079* (2023.01)    *H10N 30/87* (2023.01)
*H10N 30/853* (2023.01)

(52) Cooperative Patent Classification (CPC):
**H10N 30/50; H10N 30/8554;** H10N 30/076;
H10N 30/079

(86) International application number:
**PCT/JP2023/040248**

(87) International publication number:
**WO 2024/116761 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.11.2022 JP 2022189584**

(71) Applicant: **FUJIFILM Corporation
Tokyo 106-8620 (JP)**

(72) Inventors:
• **KOBAYASHI, Hiroyuki**
  **Ashigarakami-gun, Kanagawa 258-8577 (JP)**
• **NAKAMURA, Seigo**
  **Ashigarakami-gun, Kanagawa 258-8577 (JP)**
• **SUGIMOTO, Shinya**
  **Ashigarakami-gun, Kanagawa 258-8577 (JP)**
• **SASAKI, Tsutomu**
  **Ashigarakami-gun, Kanagawa 258-8577 (JP)**

(74) Representative: **Meissner Bolte Partnerschaft mbB
Patentanwälte Rechtsanwälte
Postfach 86 06 24
81633 München (DE)**

(54) **PIEZOELECTRIC ELEMENT AND ACTUATOR**

(57)    A piezoelectric element includes, a substrate, a first electrode, a first piezoelectric film, a second electrode, a second piezoelectric film, and a third electrode, the first electrode, the first piezoelectric film, the second electrode, the second piezoelectric film, and the third electrode being provided on the substrate in this order, in which the first piezoelectric film and the second piezoelectric film each contain a first perovskite-type oxide containing the same constituent elements as a main component, a seed layer is provided only between the first electrode and the first piezoelectric film or between the second electrode and the second piezoelectric film, one piezoelectric film that is not provided on the seed layer is polarized in a film thickness direction due to a spontaneous internal electric field, the other piezoelectric film that is provided on the seed layer satisfies, in a case in which a positive-side coercive voltage is denoted by $V_{cr}^+$ and a negative-side coercive voltage is denoted by $V_{cr}^-$, $|V_{cr}^+ + V_{cr}^-| < |V_{cr}^+ - V_{cr}^-|$, and satisfies, in a case in which a positive-side coercive voltage is denoted by $V_{cf}^+$ and a negative-side coercive voltage is denoted by $V_{cf}$ in the one piezoelectric film, $|V_{cf}^+ - V_{cf}^-| < |V_{cr}^+ - V_{cr}^-|$.

FIG. 2A

**Description**

BACKGROUND OF THE INVENTION

1. Field of the Invention

The present disclosure relates to a piezoelectric element and an actuator.

2. Description of the Related Art

As a material having excellent piezoelectric characteristics and excellent ferroelectricity, a perovskite-type oxide is known, such as lead zirconate titanate ($Pb(Zr,Ti)O_3$, hereinafter, referred to as PZT). A piezoelectric body consisting of a perovskite-type oxide is applied as a piezoelectric film in a piezoelectric element comprising a lower electrode, the piezoelectric film, and an upper electrode on a substrate. This piezoelectric element has been developed into various devices such as a memory, an ink jet head (actuator), a micromirror device, an angular velocity sensor, a gyro sensor, a piezoelectric micromachined ultrasonic transducer (PMUT), and an oscillation power generation device.

As the piezoelectric element, a lamination type piezoelectric element has been proposed in which a plurality of piezoelectric films are laminated via an electrode layer in order to obtain high piezoelectric characteristics.

For example, JP2013-80886A proposes a piezoelectric element including a first electrode, an Nb-added PZT film, a second electrode, an Nb-added PZT film, and a third electrode that are laminated in this order. It is known that the Nb-added PZT film has a direction of spontaneous polarization aligned upward with respect to the substrate during film formation. That is, the two layers of Nb-added PZT films in JP2013-80886A both have the spontaneous polarization of which the direction is aligned upward. In general, for the piezoelectric film having the spontaneous polarization of which the direction is aligned, higher piezoelectric performance can be obtained by applying an electric field in the direction that is the same as the direction of the spontaneous polarization. Therefore, in JP2013-80887A, the electric field in the direction that is the same as the direction of the spontaneous polarization is applied to each of the two Nb-added PZT films by a first drive method in which a second electrode is grounded, a positive voltage (+V) is applied to the first electrode, and a negative voltage (-V) is applied to the third electrode, a second drive method in which the first electrode is grounded, a negative voltage (-V) is applied to the second electrode, and a negative voltage (-2V) that is larger in absolute value than the second electrode is applied to the third electrode, and the like. As a result, a displacement amount that is substantially twice that of the piezoelectric element having only one layer is achieved.

In addition, JP2013-80887A proposes a piezoelectric element including a first electrode, a first piezoelectric film, a second electrode, a second piezoelectric film, and a third electrode that are laminated in this order, and a direction in which spontaneous polarization of the first piezoelectric film is aligned and a direction in which spontaneous polarization of the second piezoelectric film is aligned are different from each other. Further, as a specific example, a case is shown in which the first piezoelectric film is a Nb-added PZT film and the second piezoelectric film is a PZT film without Nb addition (hereinafter, referred to as non-doped PZT film). The Nb-added PZT film has an aligned direction of the spontaneous polarization in a state in which a poling treatment is not performed, and the non-doped PZT film has a non-aligned direction of the spontaneous polarization in a state in which the poling treatment is not performed. Therefore, by performing the poling treatment on the non-doped PZT film such that the direction of the spontaneous polarization is aligned in a direction opposite to the direction of the spontaneous polarization of the Nb-added PZT film, the direction of the spontaneous polarization of the first piezoelectric film and the direction of the spontaneous polarization of the second piezoelectric film are made different. In JP2013-80887A, by setting the first electrode and the third electrode of the piezoelectric element to have the same potential and using the second electrode as a drive electrode, the electric field in the direction that is the same as the direction of the spontaneous polarization is applied to each of the first piezoelectric film and the second piezoelectric film. Accordingly, piezoelectric performance corresponding to the two layers of piezoelectric films can be obtained with a voltage large enough to drive one layer of the piezoelectric film, so that high piezoelectric performance can be obtained at a low voltage.

SUMMARY OF THE INVENTION

However, in JP2013-80886A, in order to obtain piezoelectric performance equivalent to that of the first drive method by the second drive method in which the voltage larger in absolute value than the second electrode is applied to the third electrode, it is necessary to apply a very large voltage to the third electrode, and thus sufficient piezoelectric performance cannot be obtained at a low voltage. In order to carry out the first drive method in which the voltages of different signs are applied to the first electrode and the third electrode, it is necessary to comprise a positive drive circuit and a negative drive circuit, and thus the cost increases.

Further, in the piezoelectric element of JP2013-80887A, very good piezoelectric performance can be obtained.

However, in order to produce the piezoelectric element of JP2013-80887A, for example, the first piezoelectric film and the second piezoelectric film need to be composed of piezoelectric films containing materials different from each other such that the first piezoelectric film is the Nb-added PZT film and the second piezoelectric film is the non-doped PZT film. Therefore, two different targets are required for forming the first piezoelectric film and the second piezoelectric film, and at least one of the piezoelectric films needs to be subjected to the poling treatment, so that sufficient cost reduction cannot be achieved.

As described above, the piezoelectric element that can obtain high piezoelectric performance is expensive or requires application of a high voltage, and a piezoelectric element that can obtain high piezoelectric performance at a low voltage at a low cost has not been achieved.

An object of the present disclosure is to provide a piezoelectric element and a piezoelectric actuator that can obtain high piezoelectric performance at a low voltage at a low cost.

The present disclosure relates to a piezoelectric element comprising: a substrate; a first electrode; a first piezoelectric film; a second electrode; a second piezoelectric film; and a third electrode, the first electrode, the first piezoelectric film, the second electrode, the second piezoelectric film, and the third electrode being provided on the substrate in this order, in which the first piezoelectric film and the second piezoelectric film each contain a perovskite-type oxide as a main component, in a case in which the perovskite-type oxide is defined as a first perovskite-type oxide, a seed layer containing, as a main component, a second perovskite-type oxide that is lattice-matched with the first perovskite-type oxide is provided only between the first electrode and the first piezoelectric film or between the second electrode and the second piezoelectric film, one piezoelectric film of the first piezoelectric film or the second piezoelectric film, which is not provided on the seed layer, is polarized in a film thickness direction due to a spontaneous internal electric field, the other piezoelectric film of the first piezoelectric film or the second piezoelectric film, which is provided on the seed layer, satisfies, in a case in which a positive-side coercive voltage is denoted by $Vcr^+$ and a negative-side coercive voltage is denoted by $Vcr^-$ in a hysteresis curve showing polarization-voltage characteristics, $|Vcr^+ + Vcr^-| < |Vcr^+ - Vcr^-|$, and satisfies, in a case in which a positive-side coercive voltage is denoted by $Vcf^+$ and a negative-side coercive voltage is denoted by $Vcf^-$ in a hysteresis curve showing polarization-voltage characteristics of the one piezoelectric film, $|Vcf^+ - Vcf^-| < |Vcr^+ - Vcr^-|$, here, a unit of the coercive voltage is [V] in all cases, and in a case in which the other piezoelectric film is directly provided on the first electrode or on the second electrode, the other piezoelectric film is a piezoelectric film that is polarized in a direction that is the same as a direction of the polarization of the one piezoelectric film due to a spontaneous internal electric field.

The positive-side coercive voltage $Vcf^+$ and the negative-side coercive voltage $Vcf^-$ in the hysteresis curve showing the polarization-voltage characteristics of the one piezoelectric film may have the same sign.

It is preferable that $|Vcf^+ + Vcf^-|/2 \geq 3$ [V], $[Vcf^+ - Vcf^-] \leq 9$ [V], and $1.4 \leq |Vcr^+ - Vcr^-|/|Vcf^+ - Vcf^-| \leq 2.0$ are satisfied.

The perovskite-type oxide that is the main component of the first piezoelectric film and the perovskite-type oxide that is the main component of the second piezoelectric film may consist of the same elements.

It is preferable that the first perovskite-type oxide is represented by $Pb_a\{(Zr_xTi_{1-x})_{1-y}M_y\}O_3$, where M is a metal element selected from the group consisting of V, Nb, Ta, Sb, Mo, and W, and $0 < x < 1$, $0 < y < 1$ and $0.9 \leq a \leq 1.2$.

It is preferable that the second perovskite-type oxide has conductivity.

It is preferable that the second perovskite-type oxide has a lattice constant of 0.39 nm to 0.405 nm in a case in which the second perovskite-type oxide is regarded as a pseudo-cubic crystal.

It is preferable that the second perovskite-type oxide is $SrRuO_3$ or $BaRuO_3$.

It is preferable that the seed layer is provided between the first electrode and the first piezoelectric film, and the first piezoelectric film is the other piezoelectric film.

It is preferable that the metal element M in the first perovskite-type oxide is Nb, and at least y in a composition ratio of the first perovskite-type oxide contained in each of the first piezoelectric film and the second piezoelectric film is the same for the first piezoelectric film and the second piezoelectric film.

It is preferable that, during driving, an electric field in a direction that is the same as the direction of the polarization of the one piezoelectric film is applied to the one piezoelectric film, and an electric field in a direction opposite to the direction of the electric field applied to the one piezoelectric film is applied to the other piezoelectric film.

The second electrode may be maintained at a ground potential, and the first electrode and the third electrode may be drive electrodes for applying a drive voltage to the first piezoelectric film and the second piezoelectric film.

The first electrode and the third electrode may be maintained at a ground potential, and the second electrode may be a drive electrode for applying a drive voltage to the first piezoelectric film and the second piezoelectric film.

The first electrode and the third electrode may be connected to each other.

The present disclosure relates to an actuator comprising: the piezoelectric element according to the present disclosure; and a drive circuit that applies a drive voltage to the piezoelectric element, in which the drive circuit applies an electric field in a direction that is the same as the direction of the polarization of the one piezoelectric film to the one piezoelectric film, and applies an electric field in a direction opposite to the direction of the electric field applied to the one piezoelectric film to the other piezoelectric film.

According to the technology of the present disclosure, it is possible to provide the piezoelectric element and the actuator that can obtain high piezoelectric performance at a low voltage at a low cost.

BRIEF DESCRIPTION OF THE DRAWINGS

Fig. 1 is a cross-sectional view of a piezoelectric element according to an embodiment.
Fig. 2A is a diagram showing a polarization-voltage hysteresis curve of one piezoelectric film, and Fig. 2B is a diagram showing a polarization-voltage hysteresis curve of the other piezoelectric film.
Fig. 3 is a cross-sectional view of a piezoelectric element according to a modification example.
Fig. 4 is a diagram showing a schematic configuration of an actuator.
Fig. 5 is a diagram showing a schematic configuration of an actuator according to a modification example.
Fig. 6 is a diagram showing a schematic configuration of the actuator comprising the piezoelectric element according to the modification example.
Fig. 7 is a cross-sectional view of the piezoelectric element according to the modification example.
Fig. 8 is a diagram showing a problem of a lamination type piezoelectric element.
Fig. 9A is a hysteresis curve of a first piezoelectric film 114, Fig. 9B is a hysteresis curve of a second piezoelectric film 118, and Fig. 9C is a diagram showing a displacement amount of a piezoelectric element 101 with respect to a voltage.
Fig. 10 is an explanatory diagram of an effect of the piezoelectric element according to the present embodiment.
Fig. 11 is a diagram showing polarization-voltage hysteresis curves of a first piezoelectric film and a second piezoelectric film according to Comparative Example 1.
Fig. 12 is a graph showing polarization-voltage hysteresis curves of a first piezoelectric film and a second piezoelectric film according to Example 1.
Fig. 13 is a graph showing a voltage dependence of a piezoelectric constant $d_{31}$ in a low-voltage region for piezoelectric elements according to Examples and Comparative Example.

DESCRIPTION OF THE PREFERRED EMBODIMENTS

Hereinafter, an embodiment according to the present invention will be described with reference to the accompanying drawings. It should be noted that, in the following drawings, a layer thickness of each of layers and a ratio thereof are changed as appropriate and drawn for easy visibility, and thus the layer thickness and the ratio do not necessarily reflect the actual layer thickness and ratio.

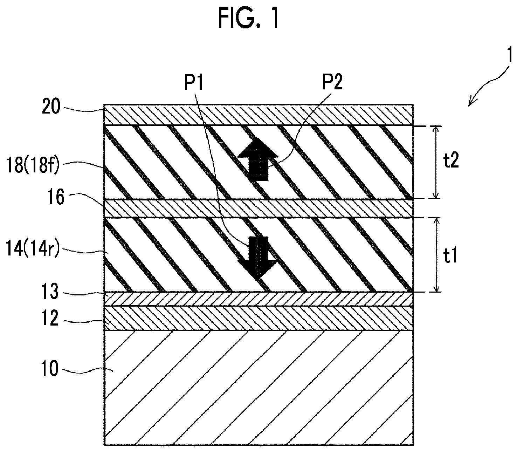

Fig. 1 is a cross-sectional schematic view showing a layer configuration of a piezoelectric element 1 according to the embodiment. As shown in Fig. 1, the piezoelectric element 1 comprises a substrate 10 and a first electrode 12, a first piezoelectric film 14, a second electrode 16, a second piezoelectric film 18, and a third electrode 20 that are provided on the substrate 10 in this order.

The substrate 10 is not particularly limited, and examples thereof include silicon, glass, stainless steel, yttrium-stabilized zirconia, alumina, sapphire, silicon carbide, and other substrates. As the substrate 10, a laminated substrate, such as a thermal oxide film-attached silicon substrate having a $SiO_2$ oxide film formed on a surface of a silicon substrate, may be used. Further, as the substrate 10, a resin substrate, such as polyethylene terephthalate (PET), polyethylene naphthalata (PEN), and polyimide, may be used.

The first electrode 12 is formed on the substrate 10. A main component of the first electrode 12 is not particularly limited, and examples thereof include metals such as gold (Au), platinum (Pt), iridium (Ir), ruthenium (Ru), titanium (Ti), molybdenum (Mo), tantalum (Ta), and aluminum (Al) or metal oxides, and combinations thereof. In addition, indium tin oxide (ITO) and the like may be used.

The second electrode 16 is laminated on the first piezoelectric film 14, and the third electrode 20 is laminated on the second piezoelectric film 18. The first electrode 12 and the second electrode 16 are paired with each other and apply a voltage to the first piezoelectric film 14. In addition, the second electrode 16 and the third electrode 20 are paired with each other and apply a voltage to the second piezoelectric film 18.

Main components of the second electrode 16 and the third electrode 20 are not particularly limited, and examples thereof include, in addition to the materials described for the first electrode 12, electrode materials that are generally used in a semiconductor process such as Cr and combinations thereof.

Thicknesses of the first electrode 12, the second electrode 16, and the third electrode 20 are not particularly limited, and are preferably about 50 nm to 300 nm, and more preferably 100 nm to 300 nm.

The first piezoelectric film 14 and the second piezoelectric film 18 each contain a perovskite-type oxide represented by General Formula $ABO_3$ as the main component. In the present specification, the main component means a component occupying 80 mol% or more. It is preferable that 90 mol% or more of each of the first piezoelectric film 14 and the second piezoelectric film 18 is occupied by the perovskite-type oxide, and it is more preferable that the first piezoelectric film 14 and the second piezoelectric film 18 consist of the perovskite-type oxide (however, containing unavoidable impurities). The perovskite-type oxide that is the main component of the first piezoelectric film 14 and the perovskite-type oxide that is the main component of the second piezoelectric film 18 may be composed of different constituent elements, or may have the same constituent elements. It should be noted that the phrase "have the same constituent elements" means that the contained elements are the same as each other, but composition ratios thereof may be different from each other.

It is preferable that the first piezoelectric film 14 and the second piezoelectric film 18 contain, as the main component, a perovskite-type oxide containing lead (Pb) at an A site, zirconium (Zr) at a B site, titanium (Ti), and a metal element M. The perovskite-type oxide is represented by the following general formula.

$$Pb_a\{(Zr_xTi_{1-x})_{1-y}M_y\}O_3$$

Here, the metal element M is one or more elements selected from vanadium (V), niobium (Nb), tantalum (Ta), antimony (Sb), molybdenum (Mo), and tungsten (W). In addition, $0 < x < 1$, $0 < y < 1$, and $0.9 \le a \le 1.2$ are satisfied. Hereinafter, $Pb_a\{(Zr_xTi_{1-x})_{1-y}M_y\}O_3$ will be referred to as an M-added PZT. It should be noted that, for example, in a case in which the metal element M is Nb, it is referred to as Nb-added PZT. Although a reference molar ratio a of Pb is 1, in a range of $0.9 \le a \le 1.2$, a perovskite-type structure can be obtained.

The metal element M may be a single element composed of only V, only Nb, or the like, or may be a combination of two or three or more elements, such as a mixture of V and Nb or a mixture of V, Nb, and Ta. In a case in which the metal element M is these elements, a very high piezoelectric constant can be achieved in combination with Pb of the A site element.

In particular, $Pb_a\{(Zr_xTi_{1-x})_{1-y}M_y\}O_3$ in which the metal element M is Nb is optimal. In this case, in a case in which y > 0.1, a higher piezoelectric constant can be obtained. In a case in which the piezoelectric film is formed by a vapor phase growth method such as sputtering using the Nb-added PZT in which M is Nb, the piezoelectric film having a very high piezoelectric constant can be obtained.

It is preferable that both the first piezoelectric film 14 and the second piezoelectric film 18 contain the Nb-added PZT as the main component. In this case, it is preferable that a Nb composition ratio of the Nb-added PZT that is the main component of the first piezoelectric film 14 and a Nb composition ratio of the Nb-added PZT that is the main component of the second piezoelectric film 18 are the same as each other. That is, in a case in which, in the first piezoelectric film 14, a Pb composition ratio is denoted by a1, a Zr composition ratio is denoted by x1, and an M composition ratio is denoted by y1, and, in the perovskite-type oxide in the second piezoelectric film 18, a Pb composition ratio is denoted by a2, a Zr composition ratio is denoted by x2, and an M composition ratio is denoted by y2, it is preferable that y1 = y2. It is more preferable that x1 and x2 are the same, in addition to y1 = y2. Here, the fact that the composition ratios are the same as each other means that the composition ratios are equal to each other within a range of a measurement error. As a method of measuring the composition, there are a plurality of analysis methods such as inductively coupled plasma (ICP) emission spectroscopy and X-ray fluorescence (XRF). For example, in a case in which composition analysis is performed by XRF, the measurement error is about 0.005.

It should be noted that, in the PZT-based perovskite-type oxide, high piezoelectric characteristics are exhibited at a morphotropic phase boundary (MPB) and its vicinity. Zr:Ti (molar ratio) of around 52:48 is an MPB composition, and in the above general formula, the MPB composition or its vicinity is preferable. The "MPB or its vicinity" means a region in which a phase transition occurs in a case in which an electric field is applied to the piezoelectric film. Specifically, Zr:Ti (molar ratio) is preferably in a range of 45:55 to 55:45, that is, in a range of x = 0.45 to 0.55.

A film thickness t1 of the first piezoelectric film 14 and a film thickness t2 of the second piezoelectric film 18 are preferably 0.2 $\mu$m or more and 5 $\mu$m or less, and more preferably 1 $\mu$m or more. The film thicknesses of the first piezoelectric film 14 and the second piezoelectric film 18 may be the same as each other or different from each other. The film thickness of the first piezoelectric film 14 and the second piezoelectric film 18 are preferably 2 $\mu$m or less.

In a case in which the perovskite-type oxide that is the main component of the first piezoelectric film 14 and the second piezoelectric film 18 is defined as a first perovskite-type oxide, the piezoelectric element 1 according to the present embodiment comprises the seed layer 13 containing a second perovskite-type oxide as a main component between the first electrode 12 and the first piezoelectric film 14. The second perovskite-type oxide is lattice-matched with the first perovskite-type oxide. In addition, the second perovskite-type oxide is a perovskite-type oxide having a composition different from that of the first perovskite-type oxide (the perovskite-type oxide that is the main component of the first piezoelectric film 14 and the perovskite-type oxide that is the main component of the second piezoelectric film 18).

By comprising the seed layer 13, the crystallinity of the piezoelectric film (here, the first piezoelectric film 14) formed on the upper layer can be improved. The piezoelectric film formed on the seed layer 13 is an epitaxial film that has been epitaxially grown.

It is preferable that the second perovskite-type oxide has a lattice constant of 0.39 nm to 0.405 nm in a case in which the second perovskite-type oxide is regarded as a pseudo-cubic crystal. In a case in which the lattice constant is in this range, the lattice is matched with the perovskite-type oxide consisting of the M-added PZT, so that, in a case in which the first perovskite-type oxide is the M-added PZT, the crystallinity of the piezoelectric film formed on the upper layer can be improved.

Specific examples of the second perovskite-type oxide include $SrRuO_3$, $BaRuO_3$, and $PbTiO_3$. These elements have conductivity and have a lattice constant of 0.39 nm to 0.405 nm in a case of being regarded as a pseudo-cubic crystal.

It is preferable that the second perovskite-type oxide, which is the main component of the seed layer 13, has conductivity. It should be noted that having conductivity means having electrical resistivity sufficient to function as an electrode, and, here, being regarded as having conductivity in a case in which the electrical resistivity at 20°C is $10^{-5}$ $\Omega \cdot m$ or less.

As long as the seed layer 13 has conductivity, the seed layer 13 can function as an electrode that applies the drive voltage to the piezoelectric film together with the electrode (the first electrode 12 in the present example) as a lower layer of the seed layer 13.

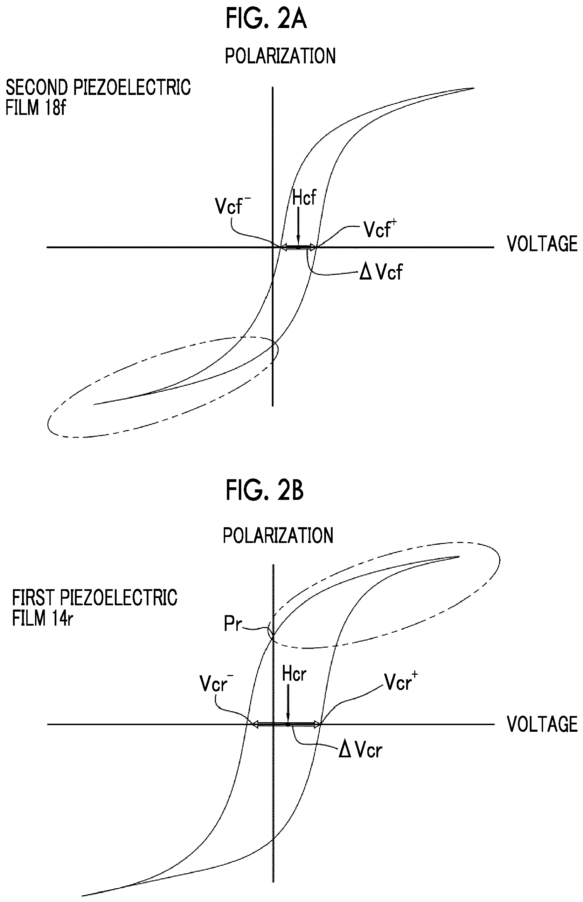

Fig. 2A is a schematic view of a P-V hysteresis curve acquired by grounding the second electrode 16 that is a lower electrode of the pair of electrodes 16 and 20 interposing the second piezoelectric film 18, applying a sweep voltage to the second piezoelectric film 18, and using the third electrode 20 that is an upper electrode as the drive electrode. In addition, Fig. 2B is a schematic view of a hysteresis curve acquired by grounding the first electrode 12 that is a lower electrode of the pair of electrodes 12 and 16 interposing the first piezoelectric film 14, using the second electrode 16 that is an upper electrode as the drive electrode, and applying a sweep voltage to the first piezoelectric film 14.

In the present example, the second piezoelectric film 18 that does not comprise the seed layer 13 between the second piezoelectric film 18 and the electrode (second electrode 16) on the substrate 10 side corresponds to one piezoelectric film in the scope of the claims. Further, the first piezoelectric film 14 comprising the seed layer 13 between first piezoelectric film 14 and the electrode (first electrode 12) on the substrate 10 side corresponds to the other piezoelectric film in the scope of the claims.

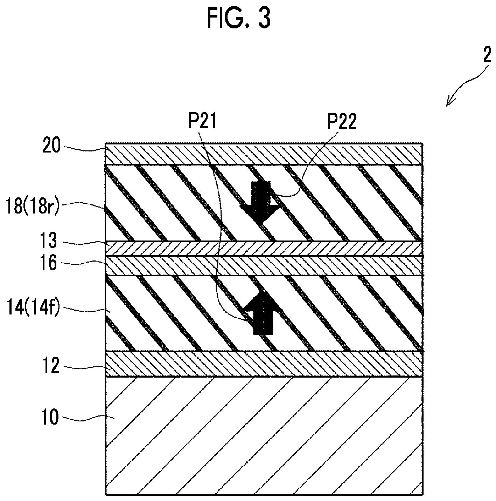

It should be noted that, in Fig. 2A, in order to indicate that the second piezoelectric film 18 is one piezoelectric film and to distinguish from the second piezoelectric film 18 in the piezoelectric element 2 of Fig. 3 described later, the second piezoelectric film 18 in the piezoelectric element 1 is shown as a second piezoelectric film 18f. In addition, in Fig. 2B in order to indicate that the first piezoelectric film 14 is the other piezoelectric film and to distinguish from the first piezoelectric film 14 in the piezoelectric element 2 of Fig. 3 described later, the first piezoelectric film 14 in the piezoelectric element 1 is shown as a first piezoelectric film 14r.

In the present example, the second piezoelectric film 18 is a film in which the spontaneous polarization is aligned upward in the film thickness direction and polarized upward in the film thickness direction in a state in which the external electric field is not applied. An arrow P2 in Fig. 1 indicates a direction of THE polarization, and, hereinafter, will be referred to as a direction P2 of the polarization. It should be noted that, in the present specification, with the substrate 10 as a reference, a direction away from the substrate 10 is defined as up and a direction close to the substrate 10 is defined as down. It should be noted that whether or not the spontaneous polarization in the piezoelectric film is aligned and the direction in which the spontaneous polarization is aligned can be confirmed by measuring a P-V hysteresis curve (or a P-E hysteresis curve) showing polarization-voltage characteristics (or polarization-electric field characteristics) of the piezoelectric film.

In the present example, the second piezoelectric film 18 is a film in which the direction of the spontaneous polarization is aligned and the film is polarized in the film thickness direction in a state immediately after the film formation without being subjected to the poling treatment. In the piezoelectric film that has not been subjected to the poling treatment, the reason why the direction of the spontaneous polarization is aligned in a state in which the external electric field is not applied is thought to be due to the generation of the electric field caused by distortion or defect of a crystal structure (hereinafter, referred to as a spontaneous internal electric field) in the piezoelectric film. The second piezoelectric film 18 has spontaneous polarization aligned in the film thickness direction due to the spontaneous internal electric field. The second piezoelectric film 18 is a piezoelectric film that is polarized in the film thickness direction in a state in which the spontaneous polarization is aligned in the film thickness direction without the application of the external electric field. The piezoelectric film is composed of a large number of domains spontaneously polarized. In the present specification, the phrase "the spontaneous polarization is aligned in a specific direction" means a state in which spontaneous polarization components in a specific direction are relatively larger than spontaneous polarization components in other directions. In a case in which the spontaneous polarization components in a specific direction are relatively larger than the spontaneous polarization components in other directions in the piezoelectric film, the piezoelectric film becomes a film polarized in the specific direction. It should be noted that, in a case in which the spontaneous polarization component in a specific direction is the maximum component as a whole of the film (that is, in a case in which the film is polarized in a specific direction), even in a state in which there is spontaneous polarization in various directions in the piezoelectric film, it is regarded that the spontaneous polarization is aligned in a specific direction. Hereinafter, the direction P2 of the polarization may be referred to as the direction P2 in which the spontaneous polarization is aligned.

In a case of a piezoelectric film in which a spontaneous internal electric field is not generated, the P-E hysteresis curve (or the P-V hysteresis curve) has a shape in which the center thereof matches the origin. On the other hand, as shown in Fig. 2A, in a case of a piezoelectric film in which a spontaneous internal electric field is generated, that is, a piezoelectric film in which the direction of the spontaneous polarization is aligned in a state in which an external electric field is not applied, the direction of spontaneous polarization is aligned with the spontaneous internal electric field, and thus the center of the hysteresis curve is deviated (shifted) from the origin. In a case of the P-E hysteresis curve, in a case in which the spontaneous internal electric field is denoted by Ei and the external electric field applied from the outside is denoted by Eo, the electric field of Ei + Eo is applied, so that the center of the hysteresis curve is shifted from the origin by an amount of the spontaneous internal electric field Ei. It should be noted that, in a case of the P-V hysteresis curve, the center of the hysteresis curve is shifted from the origin by the product of the spontaneous internal electric field Ei and the film thickness. Therefore, in a case in which the center of the measured hysteresis curve is shifted from the origin, it can be considered that the spontaneous internal electric field is generated. A shift amount from the origin of the center of the hysteresis curve is proportional to a degree of alignment of the spontaneous polarization, and the larger the shift amount, the larger the spontaneous internal electric field. In addition, the direction in which the spontaneous polarization is aligned can be specified depending on the direction of the shift from the origin of the hysteresis curve. It should be noted that, in a case of the P-V hysteresis curve, the center of the hysteresis curve is defined as a midpoint between two coercive voltages described later.

The coercive voltage is a voltage at which the polarization is zero in the hysteresis curve, and there are two coercive voltages in one hysteresis curve as shown in Figs. 2A and 2B. The positive-side coercive voltage refers to a coercive voltage on a relatively positive voltage side (right side in the drawing) of the two coercive voltages, and the negative-side coercive voltage refers to a coercive voltage on a relatively negative voltage side (left side in the drawing). In the P-V hysteresis curve showing the polarization-voltage characteristics of the second piezoelectric film 18f that is one piezoelectric film, the positive-side coercive voltage is denoted by $Vcf^+$, and the negative-side coercive voltage is denoted by $Vcf$. In the example shown in Fig. 2A, the positive-side coercive voltage $Vcf^+$ and the negative-side coercive voltage $V^-$ both have a positive (+) sign.

The fact that the positive-side coercive voltage and the negative-side coercive voltage have the same sign means that, as shown in Fig. 2A, the P-V hysteresis does not include the origin in the region inside the hysteresis curve. In the present example, in the second piezoelectric film 18f that is one piezoelectric film, the two coercive voltages have the same sign, but the positive-side coercive voltage may be a positive value, and the negative-side coercive voltage may be a negative value.

It should be noted that, in the hysteresis shown in Fig. 2A, an absolute value of a difference $Vcf^+ - Vcf^-$ of the coercive voltages is a width $\Delta Vcf$ of the hysteresis, and half of the sum of coercive voltages $(Vcf^+ + Vcf^-)/2$ indicates a center Hcf of the hysteresis. The center Hcf of the hysteresis is shifted from the origin to the positive voltage side, which indicates that the second piezoelectric film 18f has the spontaneous internal electric field. In addition, the shift of the center Hcf of the hysteresis to the positive voltage side indicates that the spontaneous internal electric field is generated in a direction opposite to the direction of the electric field in a case in which the positive voltage is applied. That is, the spontaneous internal electric field is upward in the film thickness direction from the substrate side, and the spontaneous polarization is aligned upward in the film thickness direction.

Fig. 2A shows a case in which a positive potential is applied to the third electrode 20 that is the upper electrode of the second piezoelectric film 18f as a positive voltage and a case in which a negative potential is applied to the third electrode 20 as a negative voltage. Therefore, the positive voltage is a state in which the electric field from the third electrode 20 toward the second electrode 16, that is, a downward electric field toward the substrate 10 is generated in the second piezoelectric film 18f, and the negative voltage is a state in which the electric field from the second electrode 16 toward the third electrode 20, that is, an upward electric field away from the substrate 10 is generated in the second piezoelectric film 18f. Similarly, Fig. 2B shows a case in which a positive potential is applied to the second electrode 16 which is the upper electrode of the first piezoelectric film 14r as a positive voltage and a case in which a negative potential is applied to the second electrode 16 as a negative voltage. Therefore, the positive voltage is a state in which the electric field from the second electrode 16 toward the first electrode 12, that is, a downward electric field toward the substrate 10 is generated in the first piezoelectric film 14r, and the negative voltage is a state in which the electric field from the first electrode 12 toward the second electrode 16, that is, an upward electric field away from the substrate 10 is generated in the first piezoelectric film 14r.

On the other hand, in a case in which the first piezoelectric film 14r is provided on the seed layer 13, and the positive-side coercive voltage is denoted as $Vcr^+$ and the negative-side coercive voltage is denoted as $Vcr^-$ in the hysteresis curve showing the polarization-voltage characteristics shown in Fig. 2B, $[Vcr^+ + Vcr^-] < |Vcr^+ - Vcr^-|$ is satisfied.

Here, the unit of the coercive voltage is [V] in all cases.

The right side of the expression is an absolute value of the difference in coercive voltage, and indicates a width $\Delta Vcr$ of the hysteresis curve. As described above, the center of the hysteresis curve is represented by $(Vcr^+ + Vcr^-)/2$. Therefore, the absolute value of $(Vcr^+ + Vcr^-)/2$ indicates the shift amount of the hysteresis curve. The above expression is synonymous with $|Vcr^+ + Vcr^-|/2 < [Vcr^+ - Vcr^-]/2$, and means that the shift amount of the hysteresis curve is less than half of the hysteresis width, that is, the hysteresis curve includes the origin.

The first piezoelectric film 14r is polarized in the film thickness direction, and the direction P1 of the polarization is opposite to the direction P2 of the polarization of the second piezoelectric film 18f. That is, in the first piezoelectric film 14, the spontaneous polarization is aligned in the direction opposite to the direction in which the spontaneous polarization of the second piezoelectric film 18f is aligned. The first piezoelectric film 14 is a film in which the spontaneous polarization is aligned by the poling treatment, and is polarized in the direction opposite to the direction P2 of the polarization of the second piezoelectric film 18f.

It should be noted that, as shown in Fig. 2B, the center Hcr of the hysteresis curve of the first piezoelectric film 14r is shifted from the origin to the positive voltage side, which indicates that the first piezoelectric film 14r has the spontaneous internal electric field. That is, the first piezoelectric film 14r has an internal spontaneous electric field similar to that of the second piezoelectric film 18f.

Meanwhile, the width of the hysteresis curve of the first piezoelectric film 14 is larger than the width of the hysteresis curve of the second piezoelectric film 18.

That is, the first piezoelectric film 14 and the second piezoelectric film 18 satisfy a relationship of $|Vcf^+ - Vcf^-| < |Vcr^+ - Vcr^-|$.

Since the hysteresis curve of the first piezoelectric film 14 includes the origin, and the hysteresis curve has a large width, the polarization can be performed by performing the poling treatment of applying the electric field in a direction opposite to the direction of the internal spontaneous electric field. That is, in a case in which the external voltage of the positive voltage is applied until the saturation polarization is reached and then the external voltage is set to zero, the polarization (residual polarization Pr) in the direction of the electric field in a case of the positive voltage remains.

It should be noted that, in a case in which the first piezoelectric film 14 that is the other piezoelectric film formed on the seed layer 13 is provided directly on the first electrode 12 without the seed layer 13, the first piezoelectric film 14 is a piezoelectric film polarized in the direction that is the same as the direction of the polarization of the second piezoelectric film 18 that is one piezoelectric film, due to the spontaneous internal electric field. That is, the first piezoelectric film 14 is formed on the seed layer 13 to be a film exhibiting hysteresis shown in Fig. 2B, but, in a case in which the first piezoelectric film 14 is formed on the first electrode 12, the first piezoelectric film 14 is composed of the piezoelectric material so as to be a film exhibiting hysteresis that is the same as or similar to the hysteresis shown in Fig. 2A.

The second piezoelectric film 18f and the first piezoelectric film 14r having the hysteresis characteristics shown in Figs. 2A and 2B can be obtained by, for example, performing sputter deposition using the same target of the Nb-added PZT. Even in a case in which the same target is used, a piezoelectric film having different crystallinity can be obtained by forming the first piezoelectric film 14r on the seed layer 13, forming the second piezoelectric film 18f, and forming the second electrode 16 having no seed layer 13. The piezoelectric film formed on the seed layer 13 has a perovskite-type structure having high crystallinity and high alignment as compared with the piezoelectric film formed on the electrode without comprising the seed layer 13, and exhibits a hysteresis curve having a wide hysteresis width as shown in Fig. 2B.

The piezoelectric element 1 is driven by, for example, applying a voltage in a range surrounded by a two-dot chain line in Fig. 2A to the second piezoelectric film 18f and applying a voltage in a range surrounded by a two-dot chain line in Fig. 2B to the first piezoelectric film 14r. In this case, since the electric field in the direction that is the same as the direction in which the spontaneous polarization is aligned is applied to both the second piezoelectric film 18f and the first piezoelectric film 14r, good piezoelectric performance can be obtained in the low-voltage region.

As described above, in the piezoelectric element 1, the two layers of piezoelectric films containing the perovskite-type oxide as the main component are laminated with the electrode interposed therebetween, one piezoelectric film (in the present example, the second piezoelectric film 18) among the two layers of piezoelectric films is formed on the electrode (in the present example, the second electrode 16), and the other piezoelectric film (in the present example, the first piezoelectric film 14) is formed on the seed layer 13 formed on the electrode (in the present example, the first electrode 12). One piezoelectric film has the spontaneous polarization aligned in the film thickness direction due to the spontaneous internal electric field, and the other piezoelectric film has the hysteresis curve including the origin inside the loop and having the hysteresis width wider than the hysteresis width of one piezoelectric film. With this configuration, in a case in which the piezoelectric element 1 is driven by applying an electric field in the direction that is the same as the direction of the polarization to one piezoelectric film (first piezoelectric film 14 in the example of Fig. 3) and applying an electric field in a direction opposite to the direction of the electric field applied to one piezoelectric film to the other piezoelectric film (second piezoelectric film 18 in the example of Fig. 3), good piezoelectric performance can be obtained in a low-voltage region. Here, the low-voltage region means a voltage region suitable for a case in which the piezoelectric element is assumed to be incorporated in a consumer device, and specifically, a voltage region with an absolute value of 12 V or less. It should be noted that it is preferable that high piezoelectric performance can be obtained at a voltage of 7 V or less, and further 5 V or less.

It should be noted that it is more preferable that the first piezoelectric film 14 and the second piezoelectric film 18 satisfy $|Vcf^+ + Vcf^-|/2 \geq 3$ [V], $|Vcf^+ - Vcf^-| \leq 9$ [V], and $1.4 \leq |Vcr^+ - Vcr^-|/|Vcf^+ - Vcf^-| \leq 2.0$.

It is more preferable that $1.4 \leq |Vcr^+ - Vcr^-|/|Vcr^+ - Vcf^-| \leq 1.9$.

That is, in a case in which the shift amount is large and the hysteresis width is narrow, such as a case in which the hysteresis width of one piezoelectric film (here, the second piezoelectric film 18f) formed on the electrode without the seed layer is 9 V or less and the shift amount thereof is 3 V or less, the hysteresis width of the other piezoelectric film (here, the first piezoelectric film 14r) formed on the seed layer is preferably 1.4 times or more and 2.0 times or less the hysteresis width of one piezoelectric film (see Examples to be described later). In a case in which the hysteresis width of one piezoelectric film (here, the second piezoelectric film 18f) formed on the electrode without the seed layer is 9 V or less and the shift amount thereof is 3 V or less, the effect of improving the piezoelectric performance in the low-voltage region is particularly high in a case in which the shift amount is large and the hysteresis width is narrow as compared with a case in which the two layers of piezoelectric films having the same hysteresis curve are provided,.

As described above, since both the first piezoelectric film 14 and the second piezoelectric film 18 contain the perovskite-type oxide consisting of the M-added PZT as the main component, the first piezoelectric film 14 and the second piezoelectric film 18 can be formed by using one target. By forming the first piezoelectric film 14 and the second piezoelectric film 18 using one target, it is possible to reduce the cost as compared with a case in which different targets are used.

It should be noted that the piezoelectric element 1 shown in Fig. 1 comprises the seed layer 13 is provided between the first piezoelectric film 14 and the first electrode 12, but may not comprise the seed layer 13 between the first piezoelectric film 14 and the first electrode 12 as in the piezoelectric element 2 shown in Fig. 3 and may comprise the seed layer between the second piezoelectric film 18 and the second electrode 16. It should be noted that, in the drawings in and after Fig. 3, the same components as those in Fig. 1 are denoted by the same references. In a case of the piezoelectric element 2 shown in Fig. 3, the first piezoelectric film 14 formed on the first electrode 12 without the seed layer 13 is a piezoelectric film polarized in a direction indicated by an arrow P21 due to the alignment of the spontaneous polarization in the film thickness direction due to the spontaneous internal electric field. The first piezoelectric film 14 exhibits the hysteresis characteristics shown in Fig. 2A. Further, the second piezoelectric film 18 formed on the seed layer 13 is a piezoelectric film exhibiting the hysteresis characteristics shown in Fig. 2B. The second piezoelectric film 18 is polarized in a direction P22 opposite to the direction P21 of the polarization of the first piezoelectric film 14. That is, the spontaneous polarization of the second piezoelectric film 18 is aligned in the direction opposite to the direction P21 in which the spontaneous polarization of the first piezoelectric film 14 is aligned. In a case of the piezoelectric element 2 of Fig. 3, the first piezoelectric film 14 corresponds to one piezoelectric film, and the second piezoelectric film 18 corresponds to the other piezoelectric film in the scope of the claims. Hereinafter, the first piezoelectric film 14 that is one piezoelectric film may be referred to as a first piezoelectric film 14f, and the second piezoelectric film 18 that is the other piezoelectric film may be referred to as a second piezoelectric film 18r.

However, it is more preferable that the seed layer 13 is provided in the lower layer of the first piezoelectric film 14 disposed on the substrate 10 side as in the piezoelectric element 1 shown in Fig. 1. By forming a film on the seed layer 13, the crystallinity of the first piezoelectric film 14 is improved, so that the roughness of the surface can be suppressed. In a case in which the surface roughness of the first piezoelectric film 14 disposed on the substrate side is small, the surface roughness of the second piezoelectric film 18 to be formed thereafter can also be suppressed. The smaller the surface roughness of the first piezoelectric film 14 and the second piezoelectric film 18, the higher the piezoelectric characteristics tend to be obtained.

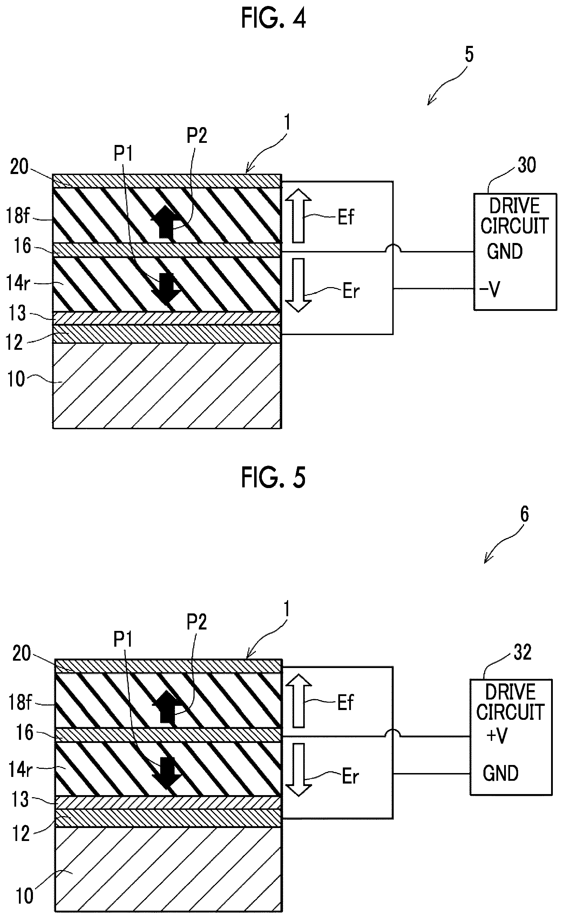

Fig. 4 shows a schematic configuration of an actuator 5 comprising the piezoelectric element 1. The actuator 5 comprises the piezoelectric element 1 and a drive circuit 30.

The drive circuit 30 is means for supplying a drive voltage to the first piezoelectric film 14r and the second piezoelectric film 18f interposed between the electrodes in order to drive the piezoelectric element 1. In the present example, the second electrode 16 is connected to a ground terminal (GND) of the drive circuit 30, and the first electrode 12 and the third electrode 20 are connected to a drive voltage output terminal (-V) of the drive circuit 30. As a result, the drive circuit 30 applies the electric fields in opposite directions to the first piezoelectric film 14r and the second piezoelectric film 18f. In the present example, the drive circuit 30 applies the electric field Ef in the direction that is the same as the direction P2 in which the spontaneous polarization is aligned (direction of the polarization) to the second piezoelectric film 18f that is one piezoelectric film, and applies an electric field Er in a direction opposite to the direction of the electric field Ef applied to the second piezoelectric film 18f to the first piezoelectric film 14r that is the other piezoelectric film. The drive circuit 30 is a negative drive circuit that applies the negative potential to the drive electrode (here, the second electrode 16).

In the actuator 5 shown in Fig. 4, in the piezoelectric element 1, the second electrode 16 is set to a ground potential, and the first electrode 12 and the third electrode 20 are used as the drive electrodes. In the present example, in the piezoelectric element 1, during driving, the negative potential (-V) is applied to the drive electrodes (here, the first electrode 12 and the third electrode 20). As a result, the electric field Ef in a direction that is the same as the direction P2 in which the spontaneous polarization is aligned (direction of the polarization) is applied to the second piezoelectric film 18 that is one piezoelectric film, and the electric field Er in a direction opposite to the direction of the electric field Ef applied to the second piezoelectric film 18 is applied to the first piezoelectric film 14 that is the other piezoelectric film.

It should be noted that it is preferable that, in the piezoelectric element 1, the first electrode 12 and the third electrode 20 are connected to each other. In a case in which the first electrode 12 and the third electrode 20 are connected, the drive control is easy.

Meanwhile, as in an actuator 6 according to a modification example shown in Fig. 5, a positive drive circuit that applies a positive potential to the drive electrode may be provided as a drive circuit 32. In the example shown in Fig. 5, the first electrode 12 and the third electrode 20 are connected to the ground terminal of the drive circuit 32, and the second electrode 16 is connected to the drive voltage output terminal of the drive circuit 32. That is, the first electrode 12 and the third electrode 20 are set to the ground potential, and the second electrode 16 functions as the drive electrode. In this case as well, by the drive circuit 32, the electric field Ef in the direction that is the same as the direction P2 in which the spontaneous polarization is aligned (direction of the polarization) can be applied to the second piezoelectric film 18f, and the electric field Er in the direction opposite to the direction of the electric field Ef applied to the second piezoelectric film 18f can be applied to the first piezoelectric film 14r.

The actuators 5 and 6 comprise only a drive circuit having one polarity as the drive circuits 30 and 32, and can be achieved at a low cost. Since the actuators 5 and 6 comprise the piezoelectric element 1, high piezoelectric performance can be obtained in the low-voltage region.

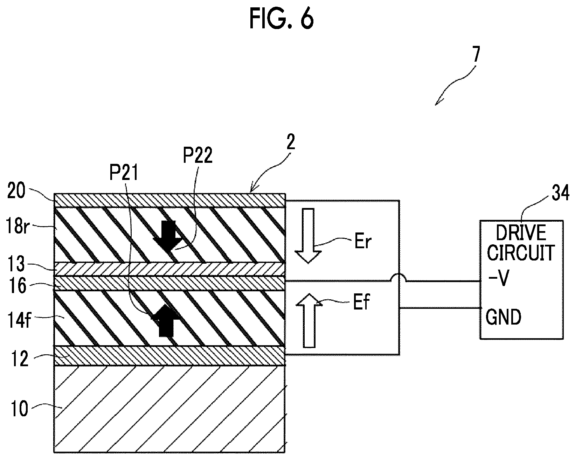

The actuator 7 shown in Fig. 6 comprises the piezoelectric element 2 shown in Fig. 3. The piezoelectric element 2 comprises the first piezoelectric film 14f that is one piezoelectric film having a hysteresis curve shown in Fig. 2A and the second piezoelectric film 18r that is the other piezoelectric film having a hysteresis curve shown in Fig. 2B. In this case, as shown in Fig. 6, by applying the electric field Ef in the direction that is the same as the direction P21 of the polarization to the first piezoelectric film 14f that is one piezoelectric film, and applying the electric field Er in the direction opposite to the direction of the electric field Ef applied to the first piezoelectric film 14f to the second piezoelectric film 18r that is the other piezoelectric film, it is possible to obtain good piezoelectric performance in a low-voltage region by the drive circuit of one polarity.

In the actuator 7 shown in Fig. 6, the first electrode 12 and the third electrode 20 are connected to the ground terminal of the drive circuit 34, and the second electrode 16 is connected to the drive voltage output terminal of the drive circuit 34. That is, the first electrode 12 and the third electrode 20 are set to the ground potential, and the second electrode 16 functions as the drive electrode. The drive circuit 34 is a negative drive circuit that applies a negative potential to the second electrode 16 that is the drive electrode, to execute negative driving. The drive circuit 34 applies the electric field Ef in the direction that is the same as the polarization direction P21 to the first piezoelectric film 14f the is one piezoelectric film, and applies the electric field Er in the direction opposite to the direction of the electric field Ef applied to the first piezoelectric film 14f to the second piezoelectric film 18r the is the other piezoelectric film.

It should be noted that the actuator may comprise the piezoelectric element 2 and the positive drive circuit, and may be configured to connect the second electrode 16 to the ground terminal and set to the ground potential and connect the first electrode 12 and the third electrode 20 to the drive power output terminal to function as the drive electrode.

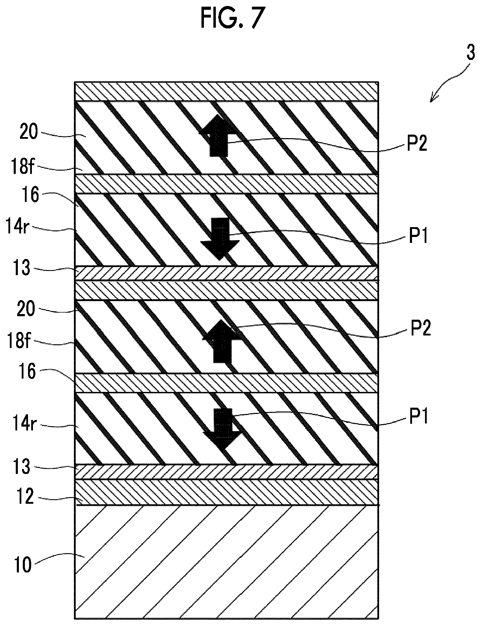

The above-described piezoelectric elements 1 and 2 are both piezoelectric elements of a two-layer lamination type in which two layers of piezoelectric films are laminated, but the piezoelectric element according to the present disclosure is not limited to having two layers and may comprise three or more layers of piezoelectric films. A plurality of the first piezoelectric films 14 (14r) formed on the seed layer 13 and a plurality of the second piezoelectric films 18 (18f) formed on the second electrode 16 may be alternately provided, or a plurality of the first piezoelectric films 14 (14f) formed on the first electrode 12 and a plurality of the second piezoelectric films 18 (18r) formed on the seed layer 13 may be alternately provided. In the piezoelectric element 3 shown in Fig. 7, the first electrode 12, the seed layer 13, the first piezoelectric film 14r, the second electrode 16, the second piezoelectric film 18f, the third electrode 20, the seed layer 13, the first piezoelectric film 14r, the second electrode 16, the second piezoelectric film 18f, and the third electrode 20 are laminated in this order on the substrate 10. In this manner, a plurality of layers of the piezoelectric film, such as one piezoelectric film (here, the second piezoelectric film 18) having the hysteresis curve shown in Fig. 2A and the other piezoelectric film (here, the first piezoelectric film 14) having the hysteresis curve shown in Fig. 2B, may be alternately provided via the electrodes.

Here, a problem in a case in which the piezoelectric films showing the hysteresis curve of Fig. 2A are laminated and a principle that the piezoelectric element 1 exhibits large piezoelectric performance in the low-voltage region will be described.

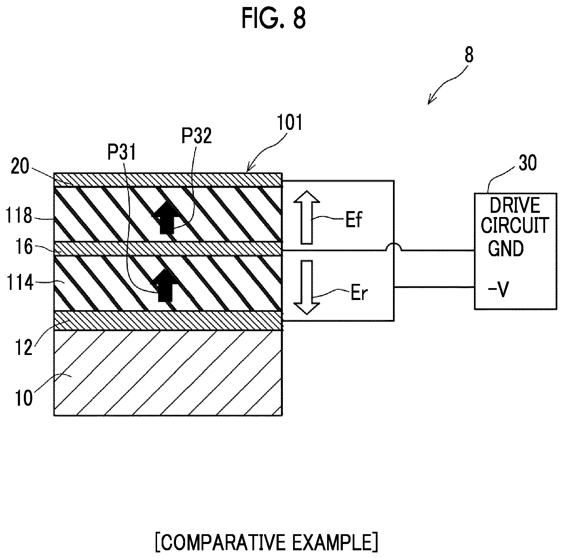

As a comparative example, the piezoelectric performance of a piezoelectric element 101 will be described, in which the piezoelectric element 101 has the same laminated structure as the piezoelectric element 1 having the layer structure shown in Fig. 1 as shown in Fig. 8, but both the first piezoelectric film 114 and the second piezoelectric film 118 are piezoelectric films exhibiting the hysteresis curve shown in Fig. 2A.

In the piezoelectric element 101 shown in Fig. 8, the seed layer 13 is not provided in both the first piezoelectric film 114 and the second piezoelectric film 118, and both the first piezoelectric film 114 and the second piezoelectric film 118 have the spontaneous polarization aligned upward in the film thickness direction due to the spontaneous internal electric field, and the directions P31 and P32 of the polarization are both upward in the film thickness direction.

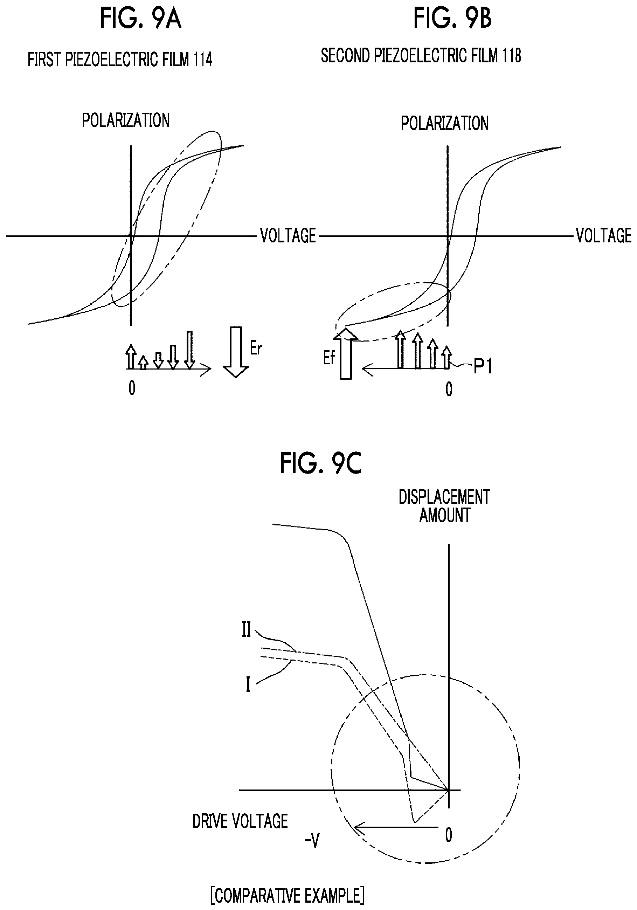

Figs. 9A and 9B show hysteresis curves acquired by grounding the lower electrode and using the upper electrode as the drive electrode for the first piezoelectric film 114 and the second piezoelectric film 118 of the piezoelectric element 101 shown in Fig. 8, respectively. The first piezoelectric film 114 and the second piezoelectric film 118 are, for example, piezoelectric films containing the first perovskite-type oxide consisting of the Nb-added PZT film as the main component.

In a case in which the piezoelectric element 101 is driven by the drive circuit 30 that is a negative drive circuit, for example, as shown in Fig. 8, the second electrode 16 is set to the ground potential, and the first electrode 12 and the third electrode 20 are set to the drive electrodes. As a result, the electric fields in opposite directions are applied to the first piezoelectric film 114 and the second piezoelectric film 118. In a case in which the negative drive potential (-V) is applied to the first electrode 12 and the third electrode 20 that are the drive electrodes, the electric field Ef in the direction that is the same as the direction (direction of polarization) P32 in which of the spontaneous polarization is aligned is applied to the second piezoelectric film 118, and the electric field Er in the direction opposite to the direction of the electric field Ef applied to the second piezoelectric film 118 is applied to the first piezoelectric film 114.

In a case in which the piezoelectric element 101 is driven by applying the negative potential -V to the drive electrode in Fig. 8, the polarization change in the third quadrant surrounded by a broken line in Fig. 9B is used for the second piezoelectric film 118, and the polarization change over the fourth quadrant to the first quadrant surrounded by a broken line in Fig. 9A is used for the first piezoelectric film 114.

In a case in which the drive potential applied to the third electrode 20 in Fig. 8 is changed from 0 to -V, the electric field Ef in the direction that is the same as the direction P32 of the polarization is applied to the second piezoelectric film 118, and thus the polarization increases as the voltage increases, as in the lower part of the graph of Fig. 9B in which the change in the polarization is schematically shown by the magnitude of the arrow. Therefore, the displacement amount of the second piezoelectric film 118 increases as V increases, as shown by a one-dot chain line II in Fig. 9C. On the other hand, in a case in which the drive potential applied to the first electrode 12 in Fig. 8 is changed from 0 to -V, the electric field Er in the direction opposite to the direction P31 of the polarization is applied to the first piezoelectric film 114. Therefore, as the drive potential is changed from 0 to -V, the polarization gradually decreases, and then the polarization is reversed by the coercive voltage, and then the polarization in the direction that is the same as the direction of the electric field Er gradually increases, as in the lower part of the hysteresis curve of Fig. 9A in which the change in the polarization is shown by the direction and the magnitude of the arrow. Therefore, the first piezoelectric film 114 is displaced in the opposite direction up to the coercive voltage at which the value of the polarization is zero, as indicated by a broken line in Fig. 9C. The change in the displacement amount of the piezoelectric element 101 behaves as the sum of the displacement amounts of both the first piezoelectric film 114 and the second piezoelectric film 118. Therefore, as indicated by a solid line in Fig. 9C, a very large displacement amount can be obtained on the high-voltage side as a whole of the piezoelectric element 101, but the displacement amount in the low-voltage region is smaller than the displacement amount obtained only by one layer of the piezoelectric film. As described above, in the piezoelectric element 101, there is a problem in that the piezoelectric characteristics in the low-voltage region are low.

The piezoelectric element 1 having the configuration shown in Fig. 1 comprises the seed layer 13 on the lower layer of the first piezoelectric film 14, as compared with the piezoelectric element 101 shown in Fig. 8. The first piezoelectric film 14r is formed on the seed layer 13, so that the crystallinity is improved, and the hysteresis width is larger than that of the hysteresis curve obtained in a case in which the first piezoelectric film 14r is directly formed on the electrode. Specifically, as described above, the first piezoelectric film 14r has a larger hysteresis width than the second piezoelectric film 18f as shown in Fig. 2B, and exhibits the hysteresis curve including the origin.

As in a case of the piezoelectric element 101, in a case in which, in the piezoelectric element 1, the electric field Ef upward in the film thickness direction is applied to the second piezoelectric film 18f and the electric field Er downward in the film thickness direction is applied to the first piezoelectric film 14r (see Fig. 4), the polarization change in the third quadrant surrounded by a broken line in Fig. 2A is used for the second piezoelectric film 18f, and the polarization change in the first quadrant surrounded by a broken line in Fig. 2B is used for the first piezoelectric film 14r.

Unlike a case of the first piezoelectric film 114 of the piezoelectric element 101, the first piezoelectric film 14r of the piezoelectric element 1 is in a poled state, and the spontaneous polarization is aligned in the direction P1 opposite to the direction P2 in which the spontaneous polarization of the second piezoelectric film 18f is aligned (see Fig. 1). Therefore, the electric field Er in the direction that is the same as the direction P1 in which the spontaneous polarization is aligned is also applied to the first piezoelectric film 14r. In the first piezoelectric film 14r, since it is not necessary to invert the direction P1 of the polarization, the piezoelectric element 1 can obtain higher piezoelectric characteristics than the piezoelectric element 101 on the low-voltage region side.

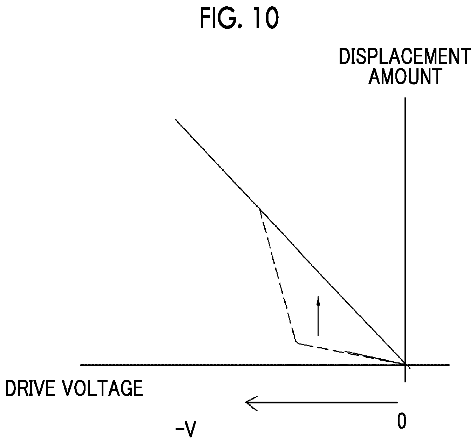

In Fig. 10, a change in the displacement amount in a case in which a drive potential of 0 to -V is applied, for driving, to the drive electrode of the piezoelectric element 101 of Fig. 8 is shown by a broken line, and a change in the displacement amount in a case in which a drive potential of 0 to -V is applied, for driving, to the drive electrode of the piezoelectric element 1 of Fig. 3 is shown by a solid line. It should be noted that Fig. 10 is a diagram showing the low-voltage region surrounded by a two-dot chain line in Fig. 9C in an enlarged manner. As shown in Fig. 10, the piezoelectric element 1 can obtain a large displacement in the low-voltage region as compared with the piezoelectric element 101.

Examples

Hereinafter, specific examples and comparative example of the piezoelectric element according to the present disclosure will be described. First, a configuration and a production method of the piezoelectric element according to each example will be described.

As Comparative Example, the piezoelectric element comprising the first electrode, the first piezoelectric film, the second electrode, the second piezoelectric film, and the third electrode in this order on the substrate (see Fig. 8) was produced.

As Examples 1 to 4, the piezoelectric element (see Fig. 1) comprising the first electrode, the seed layer, the first piezoelectric film, the second electrode, the second piezoelectric film, and the third electrode in this order on the substrate was produced.

As Examples 5 to 8, the piezoelectric element (see Fig. 3) comprising the first electrode, the first piezoelectric film, the second electrode, the seed layer, the second piezoelectric film, and the third electrode in this order on the substrate shown in Fig. 3 was produced.

The layer configurations of Comparative Example and Examples 1 to 8 are collectively shown in Table 1 shown later.

A sputtering device was used for the film formation of each layer. The film formation conditions for each layer were as follows.

(First Electrode)

As the substrate 10, a thermal oxide film-attached silicon substrate was used. The first electrode was formed on the substrate by sputtering. Specifically, as the first electrode, a TiW layer having a thickness of 50 nm and an Ir layer having a thickness of 200 nm were laminated on the substrate in this order. The sputtering conditions of each layer were as follows.

-Sputtering Conditions of TiW Layer-

Distance between target and substrate: 100 mm
Power input to target: 600 W
Ar gas pressure: 0.5 Pa
Substrate set temperature: 350°C

-Sputtering Conditions of Ir Layer-

Distance between target and substrate: 100 mm
Power input to target: 600 W
Ar gas pressure: 0.1 Pa
Substrate set temperature: 350°C

(Seed Layer)

In cases of Examples 1 to 4, the seed layer having a thickness of 30 nm was formed on the first electrode under the following sputtering conditions, and in cases of Examples 5 to 8, the seed layer having a thickness of 30 nm was formed on the second electrode under the following sputtering conditions. The seed layer in each example was set as shown in Table 1. In Table 1, SRO is $SrRuO_3$, BRO is $BaRuO_3$, and PTO is $PbTiO_3$.

-Sputtering Conditions of Seed Layer-

Distance between target and substrate: 100 mm
Power input to target: 500 W
Vacuum degree: 0.3 Pa, an $Ar/O_2$-mixed atmosphere ($O_2$ volume fraction: 10%)
Substrate set temperature: 600°C

(First Piezoelectric Film)

The Nb-added PZT film in which the Nb addition amount to the B site was 12 at% was formed as the first piezoelectric film on the first electrode in Comparative Example 1 and Examples 5 to 8 and on the seed layer in Examples 1 to 4. The Nb-added PZT was used as a target, and the sputtering conditions were set as follows. It should be noted that the Nb-added PZT target had a Pb composition ratio = 1.3, a Zr/Ti molar ratio which is the MPB composition (Zr/Ti = 52/48), that is, x = 0.52, and a Nb composition ratio y = 0.12.

-Sputtering Conditions of First Piezoelectric Film-

Distance between target and substrate: 60 mm
Power input to target: 500 W
Vacuum degree: 0.3 Pa, an Ar/$O_2$-mixed atmosphere ($O_2$ volume fraction: 10%)
Substrate set temperature: 600°C

It should be noted that the film thickness of the first piezoelectric film was set as shown in Table 1 for each of Examples and Comparative Example. The film thickness was adjusted by changing the film formation time.

(Second Electrode)

As the second electrode, $IrO_z$ ($z \leq 2$) of 50 nm and Ir of 100 nm were laminated on the first piezoelectric film in this order. The sputtering conditions were as set follows.

-Sputtering Conditions of $IrO_z$ and Ir-

Distance between target and substrate: 100 mm
Power input to target: 200 W
Vacuum degree: 0.3Pa, an Ar atmosphere during Ir film formation, an Ar/$O_2$-mixed atmosphere during $IrO_z$ film formation ($O_2$ volume fraction: 5%)
Substrate set temperature: room temperature

(Second Piezoelectric Film)

The Nb-added PZT film in which the Nb addition amount to the B site was 12 at% was formed as the second piezoelectric film on the second electrode in Comparative Example and Examples 1 to 4 and on the seed layer in Examples 5 to 8. The target and the sputtering conditions were set to be the same as those for the first piezoelectric film.

(Third Electrode)

As the third electrode, $IrO_z$ of 50 nm and Ir of 100 nm were laminated on the second piezoelectric film in this order. The sputtering conditions were set to be the same as those of the second electrode.

(Formation of Electrode Pattern for Evaluation)

In order to form an electrode pad for voltage application on the first electrode, the second electrode, and the third electrode, in a case in which the third electrode, the second piezoelectric film, the second electrode, the first piezoelectric film, and the seed layer were provided, the seed layer was further patterned by photolithography and dry etching in order.
The laminates according to Comparative Example and Examples were prepared by the above-described steps.

[Table 1]

| | First electrode | Seed layer | First piezoelectric film | | Second electrode | Seed layer | Second piezoelectric film | | Third electrode |
| --- | --- | --- | --- | --- | --- | --- | --- | --- | --- |
| | | | Composition | Thickness [μm] | | | Composition | Thickness [μm] | |
| Comparative Example | Ir/TiW | None | Nb-PZT | 2 | Ir/IrO$_z$ | None | Nb-PZT | 2 | Ir/IrO$_z$ |
| Example 1 | Ir/TiW | SRO | Nb-PZT | 2 | Ir/IrO$_z$ | None | Nb-PZT | 2 | Ir/IrO$_z$ |
| Example 2 | Ir/TiW | BRO | Nb-PZT | 2 | Ir/IrO$_z$ | None | Nb-PZT | 2 | Ir/IrO$_z$ |
| Example 3 | Ir/TiW | PTO | Nb-PZT | 2 | Ir/IrO$_z$ | None | Nb-PZT | 2 | Ir/IrO$_z$ |
| Example 4 | Ir/TiW | SRO | Nb-PZT | 1.5 | Ir/IrO$_z$ | None | Nb-PZT | 2 | Ir/IrO$_z$ |
| Example 5 | Ir/TiW | None | Nb-PZT | 2 | Ir/IrO$_z$ | SRO | Nb-PZT | 2 | Ir/IrO$_z$ |
| Example 6 | Ir/TiW | None | Nb-PZT | 2 | Ir/IrO$_z$ | BRO | Nb-PZT | 2 | Ir/IrO$_z$ |
| Example 7 | Ir/TiW | None | Nb-PZT | 2 | Ir/IrO$_z$ | PTO | Nb-PZT | 2 | Ir/IrO$_z$ |
| Example 8 | Ir/TiW | None | Nb-PZT | 2 | Ir/IrO$_z$ | SRO | Nb-PZT | 1.5 | Ir/IrO$_z$ |

(Preparation of Sample for Evaluation)

-Sample for Evaluation 1-

A striped portion of 2 mm × 25 mm was cut out from the laminate to prepare a cantilever as a sample for evaluation 1.

-Sample for Evaluation 2-

A portion of 25 mm × 25 mm having the third electrode 20 patterned in a circular shape having a diameter of 400 μm at the center of the surface of the second piezoelectric film 18 was cut out from the laminate to obtain a sample for evaluation 2.

<Measurement of Polarization-Voltage Characteristics>

For the piezoelectric elements according to each of Examples and Comparative Example, the polarization-voltage (P-V) hysteresis curve was measured by using the sample for evaluation 2. The measurement was performed by applying a voltage until the saturation polarization was reached under a condition of a frequency of 1 kHz for each of the first piezoelectric film 14 and the second piezoelectric film 18 of the piezoelectric element according to each of Examples and Comparative Example. It should be noted that, in a case of measuring the P-V characteristics of the first piezoelectric film 14, a sweep voltage was applied to the first piezoelectric film 14 by grounding the first electrode 12 and using the second electrode 16 as the drive electrode. Further, in a case of measuring the P-V characteristics of the second piezoelectric film 18, a sweep voltage was applied to the second piezoelectric film 18 by grounding the second electrode 16 and using the third electrode 20 as the drive electrode.

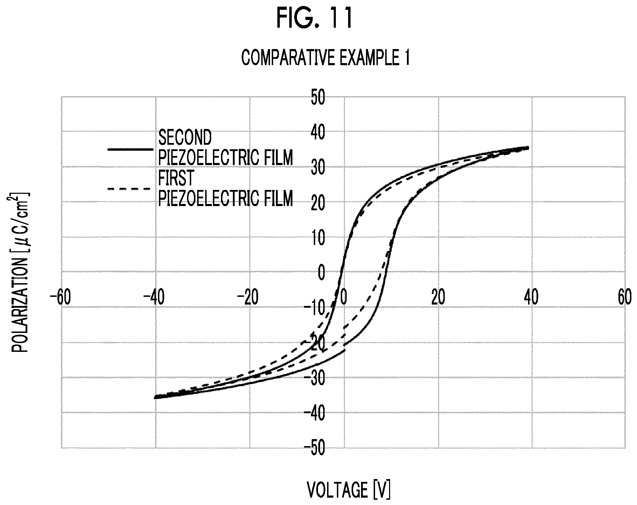

Fig. 11 is a P-V hysteresis curve for the first piezoelectric film and the second piezoelectric film according to Comparative Example 1. In Fig. 11, the hysteresis curve of the first piezoelectric film is shown by a broken line, and the hysteresis curve of the second piezoelectric film is shown by a solid line. In the hysteresis curve of the first piezoelectric film, the positive-side coercive voltage $Vc1^+$ is 7.9 V, and the negative-side coercive voltage $Vc1^-$ is -0.7 V. In the hysteresis curve of the second piezoelectric film, the positive-side coercive voltage $Vc2^+$ is 8.8 V, and the negative-side coercive voltage $Vc1^-$ is -0.6 V. It should be noted that Comparative Example 1 is an example in which the seed layer is not provided, but for convenience, in Table 2, the second piezoelectric film is regarded as one piezoelectric film and the first piezoelectric film is regarded as the other piezoelectric film.

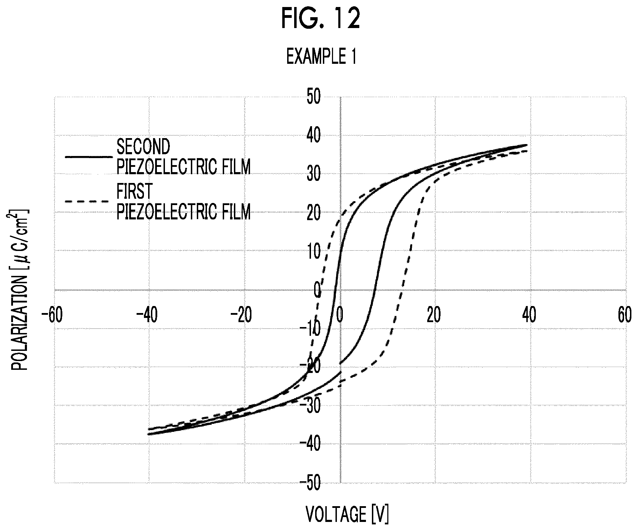

Fig. 12 is a P-V hysteresis curve for the first piezoelectric film and the second piezoelectric film according to Example 1. In Fig. 12, the hysteresis curve of the first piezoelectric film is shown by a broken line, and the hysteresis curve of the second piezoelectric film is shown by a solid line. In the hysteresis curve of the first piezoelectric film, the positive-side coercive voltage $Vc1^+$ is 13 V, and the negative-side coercive voltage $Vc1^-$ is -4.2 V. In the hysteresis curve of the second piezoelectric film, the positive-side coercive voltage $Vc2^+$ is 7.3, and the negative-side coercive voltage $Vc1^-$ is -1.1 V.

As described above, the hysteresis curves of the first piezoelectric film and the second piezoelectric film were measured for each of the other examples, and the positive-side coercive voltage and the negative-side coercive voltage were obtained. Table 3 shows the respective values.

In Examples 1 to 4, the first piezoelectric film corresponds to the other piezoelectric film, and the second piezoelectric film corresponds to one piezoelectric film. That is, in Examples 1 to 4, the positive-side coercive voltage $Vc1^+$ of the first piezoelectric film is the positive-side coercive voltage $Vcr^+$ of the other piezoelectric film, and the negative-side coercive voltage $Vc1^-$ of the first piezoelectric film is the positive-side coercive voltage $Vcr^-$ of the other piezoelectric film. In addition, the positive-side coercive voltage $Vc2^+$ of the second piezoelectric film is the positive-side coercive voltage $Vcf^+$ of one piezoelectric film, and the negative-side coercive voltage $Vc2^-$ of the second piezoelectric film is the positive-side coercive voltage Vcf of one piezoelectric film. In Examples 5 to 8, the first piezoelectric film corresponds to one piezoelectric film, and the second piezoelectric film corresponds to the other piezoelectric film. That is, in Examples 5 to 8, the positive-side coercive voltage $Vc1^+$ of the first piezoelectric film is the positive-side coercive voltage $Vcf^+$ of one piezoelectric film, and the negative-side coercive voltage $Vc1^-$ of the first piezoelectric film is the positive-side coercive voltage $Vcf^-$ of one piezoelectric film. In addition, the positive-side coercive voltage $Vc2^+$ of the second piezoelectric film is the positive-side coercive voltage $Vcr^+$ of the other piezoelectric film, and the negative-side coercive voltage $Vc2^-$ of the second piezoelectric film is the positive-side coercive voltage $Vcr^-$ of the other piezoelectric film.

Table 2 collectively shows $Vc1^+$, $Vc1^-$, $Vc2^+$, and $Vc2^-$ in each example. In addition, Table 2 shows the results of calculating $|Vcr^+ + Vcr^-|$, which is twice the shift of the hysteresis of the other piezoelectric film, $[Vcr^+ - Vcr^-]$, which is the hysteresis width, $|Vcf^+ + Vcf^-|$, which is twice the shift of the hysteresis of one piezoelectric film, and $|Vcf^+ - Vcf^-|$, which is the hysteresis width.

[Table 2]

| | First piezoelectric film | | | | Second piezoelectric film | | | | Other piezoelectric film (piezoelectric film provided on seed layer) | | One piezoelectric film (piezoelectric film provided on electrode) | |
|---|---|---|---|---|---|---|---|---|---|---|---|---|
| | $Vc1^+$ | [V] | $Vc1^-$ | [V] | $Vc2^+$ | [V] | $Vc2^-$ | [V] | $|Vcr^+ +Vcr^-|[V]$ | $|Vcr^+ - Vcr^-|[V]$ | $|Vcf^+ + Vcf^-|[V]$ | $Vcf^+ - Vcf^-|[V]$ |
| Comparative Example 1 | $Vcr^+$ | 7.5 | $Vcr^-$ | -0.7 | $Vcf^+$ | 8.0 | $Vcf^-$ | -0.5 | 6.8 | 8.2 | 7.5 | 8.5 |
| Example 1 | $Vcr^+$ | 11.9 | $Vcr^-$ | -3.9 | $Vcf^+$ | 7.0 | $Vcf^-$ | -1.0 | 8.0 | 15.8 | 6.0 | 8.0 |
| Example 2 | $Vcr^+$ | 11.8 | $Vcr^-$ | -3.9 | $Vcf^+$ | 7.2 | $Vcf^-$ | -0.8 | 7.9 | 15.7 | 6.4 | 8.0 |
| Example 3 | $Vcr^+$ | 12.2 | $Vcr^-$ | -3.9 | $Vcf^+$ | 7.1 | $Vcf$ | -0.9 | 8.3 | 16.1 | 6.2 | 8.0 |
| Example 4 | $Vcr^+$ | 9.1 | $Vcr^-$ | -3.0 | $Vcf^+$ | 7.6 | $Vcf^-$ | -0.7 | 6.1 | 12.1 | 6.9 | 8.3 |
| Example 5 | $Vcf^+$ | 7.4 | $Vcf^-$ | -0.8 | $Vcr$ | 11.7 | $Vcr^-$ | -4.0 | 7.7 | 15.7 | 6.6 | 8.2 |
| Example 6 | $Vcf^+$ | 7.4 | $Vcf^-$ | -0.7 | $Vcr^+$ | 11.4 | $Vcr^-$ | -3.9 | 7.5 | 15.3 | 6.7 | 8.1 |
| Example 7 | $Vcf^+$ | 7.5 | $Vcf^-$ | -0.7 | $Vcr$ | 12.0 | $Vcr^-$ | -4.1 | 7.9 | 16.1 | 6.8 | 8.2 |
| Example 8 | $Vcf^+$ | 7.5 | $Vcf^-$ | -0.7 | $Vcr$ | 9.1 | $Vcr^-$ | -3.1 | 6.0 | 12.2 | 6.8 | 8.2 |

<Measurement of Piezoelectric Characteristics>

The piezoelectric constant $d_{31}$ was measured for evaluating the piezoelectric characteristics for each of Examples and Comparative Example.

The measurement of the piezoelectric constant $d_{31}$ was performed by using the sample for evaluation 1. According to the method described in I. Kanno et al., Sensor and Actuator A 107 (2003) 68, the piezoelectric constant $d_{31}$ was measured.

In Comparative Example 1 and Examples 1 to 4, the piezoelectric constant $d_{31}$ was measured by grounding the second electrode 16 and using the first electrode 12 and the third electrode 20 as the drive electrodes. In Examples 5 to 8, the piezoelectric constant $d_{31}$ was measured by grounding the first electrode 12 and the third electrode 20 and using the second electrode 16 as the drive electrode. For each example, the piezoelectric constant $d_{31}$ was measured in a case in which the drive potential (applied potential) was set to each of -1, -3, -5, -7, -10, and -15 V. For example, the piezoelectric constant $d_{31}$ in a case in which the applied potential was -1 V was measured by applying the drive signal obtained by adding a sinusoidal wave having an amplitude of 0.5 V to a bias voltage of -0.5 V to the second electrode 16. The measurement results are shown in Table 3.

[Table 3]

| | Piezoelectric constant $d_{31}$ (pm/V) during each voltage application | | | | | |
|---|---|---|---|---|---|---|
| | Applied potential -1V | Applied potential -3V | Applied potential -5V | Applied potential -7V | Applied potential -10V | Applied potential -15V |
| Comparative Example 1 | 20 | 40 | 80 | 243 | 354 | 376 |
| Example 1 | 251 | 378 | 418 | 433 | 445 | 447 |
| Example 2 | 266 | 382 | 422 | 437 | 443 | 451 |
| Example 3 | 224 | 355 | 396 | 418 | 423 | 417 |
| Example 4 | 305 | 430 | 444 | 448 | 436 | 422 |
| Example 5 | 262 | 382 | 425 | 443 | 448 | 446 |
| Example 6 | 277 | 385 | 422 | 439 | 446 | 447 |
| Example 7 | 255 | 361 | 402 | 429 | 441 | 423 |

(continued)

| | Piezoelectric constant $d_{31}$ (pm/V) during each voltage application | | | | | |
|---|---|---|---|---|---|---|
| | Applied | Applied | Applied | Applied | Applied | Applied |
| | potential -1V | potential -3V | potential -5V | potential -7V | potential -10V | potential -15V |
| Example 8 | 322 | 433 | 439 | 449 | 431 | 424 |

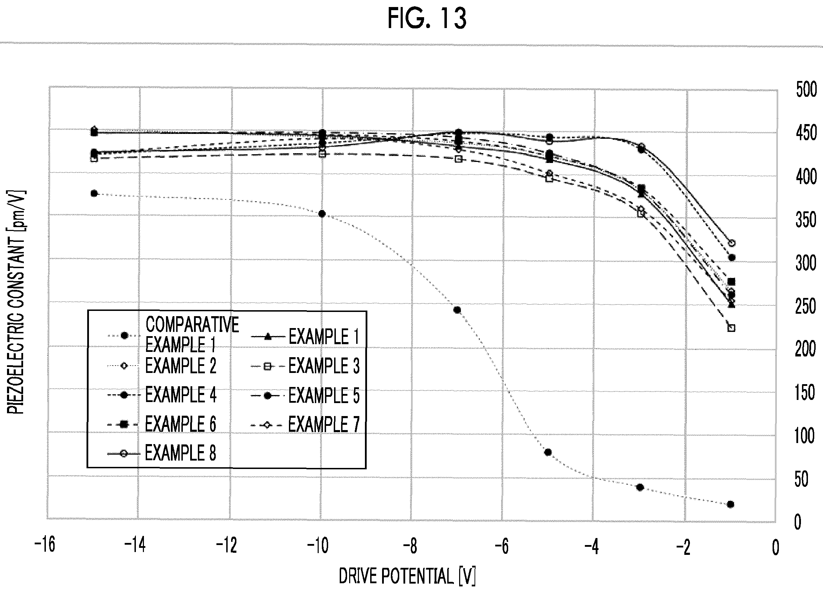

Fig. 13 is a graph showing a relationship between the drive potential and the piezoelectric constant $d_{31}$ for each piezoelectric element. In Examples 1 to 8, the piezoelectric constant significantly larger than the piezoelectric constant $d_{31}$ according to Comparative Example was obtained in a case of driving in an applied potential range of 0 to -15 V. In particular, in a case in which the applied potential is 0 to -10 V, a difference in piezoelectric constant between Examples and Comparative Example is large, and the difference thereof is particularly remarkable in a range of 0 to -5 V.

In regard to the above-described embodiment, the supplementary notes will be further disclosed as follows.

(Supplementary Note 1)

A piezoelectric element comprising: a substrate; a first electrode; a first piezoelectric film; a second electrode; a second piezoelectric film; and a third electrode, the first electrode, the first piezoelectric film, the second electrode, the second piezoelectric film, and the third electrode being provided on the substrate in this order, in which the first piezoelectric film and the second piezoelectric film each contain a perovskite-type oxide as a main component, in a case in which the perovskite-type oxide is defined as a first perovskite-type oxide, a seed layer containing, as a main component, a second perovskite-type oxide that is lattice-matched with the first perovskite-type oxide is provided only between the first electrode and the first piezoelectric film or between the second electrode and the second piezoelectric film, one piezoelectric film of the first piezoelectric film or the second piezoelectric film, which is not provided on the seed layer, is polarized in a film thickness direction due to a spontaneous internal electric field, the other piezoelectric film of the first piezoelectric film or the second piezoelectric film, which is provided on the seed layer, satisfies, in a case in which a positive-side coercive voltage is denoted by $Vcr^+$ and a negative-side coercive voltage is denoted by $Vcr^-$ in polarization-voltage characteristics, $|Vcr^+ + Vcr^-| < |Vcr^+ - Vcr^-|$, and satisfies, in a case in which a positive-side coercive voltage is denoted by $Vcf^+$ and a negative-side coercive voltage is denoted by $Vcf^-$ in a hysteresis curve showing polarization-voltage characteristics of the one piezoelectric film, $|Vcf^+ - Vcf^-| < |Vcr^+ - Vcr^-|$, here, a unit of the coercive voltage is [V] in all cases, and in a case in which the other piezoelectric film is directly provided on the first electrode or on the second electrode, the other piezoelectric film is a piezoelectric film that is polarized in a direction that is the same as a direction of the polarization of the one piezoelectric film due to a spontaneous internal electric field.

(Supplementary Note 2)

The piezoelectric element according to supplementary note 1, in which the positive-side coercive voltage $Vcf^+$ and the negative-side coercive voltage $Vcf^-$ in the hysteresis curve showing the polarization-voltage characteristics of the one piezoelectric film have the same sign.

(Supplementary Note 3)

The piezoelectric element according to supplementary note 1 or 2, in which $|Vcf^+ + Vcf^-|/2 \geq 3$ [V], $|Vcf^+ - Vcf^-| \leq 9$ [V], and $1.4 \leq |Vcr^+ - Vcr^-|/|Vcr^+ - Vcf^-| \leq 2.0$ are satisfied.

(Supplementary Note 4)

The piezoelectric element according to any one of supplementary notes 1 to 3, in which the perovskite-type oxide that is the main component of the first piezoelectric film and the perovskite-type oxide that is the main component of the second piezoelectric film consist of the same elements.

(Supplementary Note 5)

The piezoelectric element according to any one of supplementary notes 1 to 4, in which the first perovskite-type oxide is represented by $Pb_a\{(Zr_xTi_{1-x})_{1-y}M_y\}O_3$, where M is a metal element selected from the group consisting of V, Nb, Ta, Sb, Mo, and W, and $0 < x < 1$, $0 < y < 1$ and $0.9 \leq a \leq 1.2$.

(Supplementary Note 6)

The piezoelectric element according to any one of supplementary notes 1 to 5, in which the second perovskite-type oxide has conductivity.

(Supplementary Note 7)

The piezoelectric element according to any one of supplementary notes 1 to 6, in which the second perovskite-type oxide has a lattice constant of 0.39 nm to 0.405 nm in a case in which the second perovskite-type oxide is regarded as a pseudo-cubic crystal.

(Supplementary Note 8)

The piezoelectric element according to any one of supplementary notes 1 to 7, in which the second perovskite-type oxide is $SrRuO_3$ or $BaRuO_3$.

(Supplementary Note 9)

The piezoelectric element according to any one of supplementary notes 1 to 8, in which the seed layer is provided between the first electrode and the first piezoelectric film, and the first piezoelectric film is the other piezoelectric film.

(Supplementary Note 10)

The piezoelectric element according to supplementary note 5, in which the metal element M in the first perovskite-type oxide is Nb, and at least y in a composition ratio of the first perovskite-type oxide contained in each of the first piezoelectric film and the second piezoelectric film is the same for the first piezoelectric film and the second piezoelectric film.

(Supplementary Note 11)

The piezoelectric element according to any one of supplementary notes 1 to 10, in which, during driving, an electric field in a direction that is the same as the direction of the polarization of the one piezoelectric film is applied to the one piezoelectric film, and an electric field in a direction opposite to the direction of the electric field applied to the one piezoelectric film is applied to the other piezoelectric film.

(Supplementary Note 12)

The piezoelectric element according to any one of supplementary notes 1 to 11, in which the second electrode is maintained at a ground potential, and the first electrode and the third electrode are drive electrodes for applying a drive voltage to the first piezoelectric film and the second piezoelectric film.

(Supplementary Note 13)

The piezoelectric element according to any one of supplementary notes 1 to 11, in which the first electrode and the third electrode are maintained at a ground potential, and the second electrode is a drive electrode for applying a drive voltage to the first piezoelectric film and the second piezoelectric film.

(Supplementary Note 14)

The piezoelectric element according to any one of supplementary notes 1 to 13, in which the first electrode and the third electrode are connected to each other.

(Supplementary Note 15)

An actuator comprising: the piezoelectric element according to any one of supplementary notes 1 to 14; and a drive circuit that applies a drive voltage to the piezoelectric element, in which the drive circuit applies an electric field in a direction that is the same as the direction of the polarization of the one piezoelectric film to the one piezoelectric film, and applies an electric field in a direction opposite to the direction of the electric field applied to the one piezoelectric film to the other piezoelectric film.

It should be noted that the disclosure of JP2022-189584 filed on November 28, 2022 is incorporated in the present specification in its entirety by reference. All of the documents, the patent applications, and the technical standards described in the present specification are incorporated into the present specification by reference to the same extent as in a case in which each of the documents, the patent applications, and the technical standards are specifically and individually stated to be described by reference.

Explanation of References

1, 2, 3, 101: piezoelectric element
5, 6, 7: actuator
10: substrate
12: first electrode
13: seed layer
14, 114: first piezoelectric film
14f: first piezoelectric film that is one piezoelectric film
14r: first piezoelectric film that is other piezoelectric film
16: second electrode
18, 118: second piezoelectric film
18f: second piezoelectric film that is one piezoelectric film
18r: second piezoelectric film that is the other piezoelectric film
20: third electrode
30, 32, 34: drive circuit

**Claims**

1. A piezoelectric element comprising:

   a substrate;
   a first electrode;
   a first piezoelectric film;
   a second electrode;
   a second piezoelectric film; and
   a third electrode,
   the first electrode, the first piezoelectric film, the second electrode, the second piezoelectric film, and the third electrode being provided on the substrate in this order,
   wherein the first piezoelectric film and the second piezoelectric film each contain a perovskite-type oxide as a main component,
   in a case in which the perovskite-type oxide is defined as a first perovskite-type oxide, a seed layer containing, as a main component, a second perovskite-type oxide that is lattice-matched with the first perovskite-type oxide is provided only between the first electrode and the first piezoelectric film or between the second electrode and the second piezoelectric film,
   one piezoelectric film of the first piezoelectric film or the second piezoelectric film, which is not provided on the seed layer, is polarized in a film thickness direction due to a spontaneous internal electric field,
   the other piezoelectric film of the first piezoelectric film or the second piezoelectric film, which is provided on the seed layer,

   satisfies, in a case in which a positive-side coercive voltage is denoted by $Vcr^+$ and a negative-side coercive voltage is denoted by $Vcr^-$ in polarization-voltage characteristics,

$$|Vcr^+ + Vcr^-| < |Vcr^+ - Vcr^-|,$$

   and
   satisfies, in a case in which a positive-side coercive voltage is denoted by $Vcf^+$ and a negative-side coercive voltage is denoted by Vcf in a hysteresis curve showing polarization-voltage characteristics of the one piezoelectric film,

$$|Vcf^+ - Vcf^-| < |Vcr^+ - Vcr^-|,$$

here, a unit of the coercive voltage is [V] in all cases, and
in a case in which the other piezoelectric film is directly provided on the first electrode or on the second electrode, the other piezoelectric film is a piezoelectric film that is polarized in a direction that is the same as a direction of the polarization of the one piezoelectric film due to a spontaneous internal electric field.

2. The piezoelectric element according to claim 1,
wherein the positive-side coercive voltage $Vcf^+$ and the negative-side coercive voltage Vcf in the hysteresis curve showing the polarization-voltage characteristics of the one piezoelectric film have the same sign.

3. The piezoelectric element according to claim 1 or 2,

wherein

$$|Vcf^+ + Vcf^-|/2 \geq 3 \ [V],$$

$$|Vcf^+ - Vcf^-| \leq 9 \ [V],$$

and

$$1.4 \leq |Vcr^+ - Vcr^-|/|Vcf^+ - Vcf^-| \leq 2.0$$

are satisfied.

4. The piezoelectric element according to claim 1 or 2,
wherein the perovskite-type oxide that is the main component of the first piezoelectric film and the perovskite-type oxide that is the main component of the second piezoelectric film consist of the same elements.

5. The piezoelectric element according to claim 1 or 2,

wherein the first perovskite-type oxide is represented by $Pb_a\{(Zr_xTi_{1-x})_{1-y}M_y\}O_3$,
where M is a metal element selected from the group consisting of V, Nb, Ta, Sb, Mo, and W, and

$$0 < x < 1, \ 0 < y < 1 \text{ and } 0.9 \leq a \leq 1.2.$$

6. The piezoelectric element according to claim 1 or 2,
wherein the second perovskite-type oxide has conductivity.

7. The piezoelectric element according to claim 1 or 2,
wherein the second perovskite-type oxide has a lattice constant of 0.39 nm to 0.405 nm in a case in which the second perovskite-type oxide is regarded as a pseudo-cubic crystal.

8. The piezoelectric element according to claim 1 or 2,
wherein the second perovskite-type oxide is $SrRuO_3$ or $BaRuO_3$.

9. The piezoelectric element according to claim 1 or 2,

wherein the seed layer is provided between the first electrode and the first piezoelectric film, and
the first piezoelectric film is the other piezoelectric film.

10. The piezoelectric element according to claim 5,

wherein the metal element M in the first perovskite-type oxide is Nb, and
at least y in a composition ratio of the first perovskite-type oxide contained in each of the first piezoelectric film and the second piezoelectric film is the same for the first piezoelectric film and the second piezoelectric film.

11. The piezoelectric element according to claim 1 or 2,
wherein, during driving, an electric field in a direction that is the same as the direction of the polarization of the one piezoelectric film is applied to the one piezoelectric film, and an electric field in a direction opposite to the direction of the electric field applied to the one piezoelectric film is applied to the other piezoelectric film.

12. The piezoelectric element according to claim 1 or 2,
wherein the second electrode is maintained at a ground potential, and the first electrode and the third electrode are drive electrodes for applying a drive voltage to the first piezoelectric film and the second piezoelectric film.

13. The piezoelectric element according to claim 1 or 2,
wherein the first electrode and the third electrode are maintained at a ground potential, and the second electrode is a drive electrode for applying a drive voltage to the first piezoelectric film and the second piezoelectric film.

14. The piezoelectric element according to claim 1 or 2,
wherein the first electrode and the third electrode are connected to each other.

15. An actuator comprising:

the piezoelectric element according to claim 1 or 2; and
a drive circuit that applies a drive voltage to the piezoelectric element,
wherein the drive circuit applies an electric field in a direction that is the same as the direction of the polarization of the one piezoelectric film to the one piezoelectric film, and applies an electric field in a direction opposite to the direction of the electric field applied to the one piezoelectric film to the other piezoelectric film.

FIG. 1

## FIG. 2A

POLARIZATION

SECOND PIEZOELECTRIC
FILM 18f

$Vcf^-$    Hcf

$Vcf^+$

VOLTAGE

$\Delta Vcf$

## FIG. 2B

POLARIZATION

FIRST PIEZOELECTRIC
FILM 14r

Pr

$Vcr^-$    Hcr    $Vcr^+$

VOLTAGE

$\Delta Vcr$

# FIG. 3

FIG. 4

FIG. 5

## FIG. 6

FIG. 7

FIG. 8

[COMPARATIVE EXAMPLE]

# FIG. 9A

FIRST PIEZOELECTRIC FILM 114

# FIG. 9B

SECOND PIEZOELECTRIC FILM 118

# FIG. 9C

[COMPARATIVE EXAMPLE]

FIG. 10

DISPLACEMENT
AMOUNT

DRIVE VOLTAGE

−V

0

## FIG. 11

### COMPARATIVE EXAMPLE 1

# FIG. 12

EXAMPLE 1

FIG. 13

# INTERNATIONAL SEARCH REPORT

| | International application No. |
|---|---|
| | **PCT/JP2023/040248** |

### A. CLASSIFICATION OF SUBJECT MATTER

***H10N 30/045***(2023.01)i; ***H10N 30/06***(2023.01)i; ***H10N 30/20***(2023.01)i; ***H10N 30/50***(2023.01)i; ***H10N 30/079***(2023.01)i; ***H10N 30/87***(2023.01)i; ***H10N 30/853***(2023.01)i

FI: H10N30/045; H10N30/853; H10N30/50; H10N30/20; H10N30/87; H10N30/06; H10N30/079

According to International Patent Classification (IPC) or to both national classification and IPC

### B. FIELDS SEARCHED

Minimum documentation searched (classification system followed by classification symbols)

H10N30/045; H10N30/06; H10N30/20; H10N30/50; H10N30/079; H10N30/87; H10N30/853

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2007-59525 A (FUJIFILM CORP.) 08 March 2007 (2007-03-08)<br>paragraphs [0006], [0007], [0011], [0012], [0018]-[0020], fig. 1, 2 | 1-15 |
| A | WO 2016/175013 A1 (MURATA MANUFACTURING CO., LTD.) 03 November 2016 (2016-11-03)<br>paragraphs [0079]-[0089], fig. 31 | 1-15 |
| A | JP 2016-143806 A (MITSUBISHI MATERIALS CORP.) 08 August 2016 (2016-08-08)<br>paragraphs [0022], [0024], [0050], [0084], [0087], fig. 1 | 1-15 |
| A | JP 2010-84180 A (FUJIFILM CORP.) 15 April 2010 (2010-04-15)<br>entire text, all drawings | 1-15 |
| A | WO 2016/190110 A1 (KONICA MINOLTA, INC.) 01 December 2016 (2016-12-01)<br>entire text, all drawings | 1-15 |

☑ Further documents are listed in the continuation of Box C.　　☑ See patent family annex.

| | |
|---|---|
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **12 January 2024** | **23 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
|---|
| **PCT/JP2023/040248** |

| C. | DOCUMENTS CONSIDERED TO BE RELEVANT | |
|---|---|---|
| Category* | Citation of document, with indication, where appropriate, of the relevant passages | Relevant to claim No. |
| A | WO 2022/168800 A1 (THE UNIVERSITY OF TOKYO) 11 August 2022 (2022-08-11) entire text, all drawings | 1-15 |

Form PCT/ISA/210 (second sheet) (July 2022)

**INTERNATIONAL SEARCH REPORT**
Information on patent family members

International application No.

**PCT/JP2023/040248**

| Patent document cited in search report | | | Publication date (day/month/year) | Patent family member(s) | Publication date (day/month/year) |
|---|---|---|---|---|---|
| JP | 2007-59525 | A | 08 March 2007 | (Family: none) | |
| WO | 2016/175013 | A1 | 03 November 2016 | US 2018/0069168 A1 paragraphs [0147]-[0157], fig. 31 | |
| JP | 2016-143806 | A | 08 August 2016 | US 2017/0222127 A1 paragraphs [0029], [0031], [0032], [0077], [0182], [0184], fig. 3 WO 2015/147259 A1 EP 3125317 A1 KR 10-2016-0138417 A CN 106104826 A | |
| JP | 2010-84180 | A | 15 April 2010 | US 2010/0079555 A1 entire text, all drawings | |
| WO | 2016/190110 | A1 | 01 December 2016 | US 2018/0170044 A1 entire text, all drawings EP 3306687 A1 | |
| WO | 2022/168800 | A1 | 11 August 2022 | (Family: none) | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013080886 A
- JP 2013080887 A

- JP 2022189584 A